# EUROPÄISCHE PATENTSCHRIFT

(11) **EP 1 202 282 B1**
(45) Veröffentlichungstag und Bekanntmachung des Hinweises auf die Patenterteilung: **26.11.2008**
(21) Anmeldenummer: 01124042.1
(22) Anmeldetag: 09.10.2001
(51) Int. Cl.: G11C 8/08, G11C 8/10, G11C 8/18

(54) **Integrierter Speicher mit Zeilenzugriffsteuerung zur Aktivierung und Deaktivierung von Zeilenleitungen**
Integrated memory with row line access control for asserting or de-asserting row conductors
Mémoire intégrée avec commande d'accès de rangées pour activer et désactiver des conducteurs de rangées

(30) Priorität: 27.10.2000 DE 10053425
(43) Veröffentlichungstag der Anmeldung: 02.05.2002
(73) Patentinhaber: Infineon Technologies AG, 81669 München (DE)
(72) Erfinder: Dietrich, Stefan, Dr., 82299 Tuerkenfeld (DE); Hein, Thomas, 81379 München (DE); Heyne, Patrick, 81243 München (DE); Marx, Thilo, 78048 Villingen-Schwenningen (DE); Partsch, Torsten, Chapel Hill, NC 27514 (US); Schoeniger, Sabine, 83734 Hausham (DE); Schroegmeier, Peter, 81547 München (DE); Sommer, Michael, 81541 München (DE); Weis, Christian, 82110 Germering (DE)
(74) Vertreter: Epping - Hermann - Fischer

(56) Entgegenhaltungen:
- US-A- 5 357 479
- US-A- 6 108 245
- US-A- 6 131 149
- US-B1- 6 434 082

## Beschreibung

Die vorliegende Erfindung betrifft einen integrierten Speicher mit einem Speicherzellenfeld, das Spaltenleitungen und Zeilenleitungen aufweist, mit Speicherzellen, die jeweils mit einer der Zeilenleitungen zur Auswahl einer der Speicherzellen und mit einer der Spaltenleitungen zum Auslesen oder Schreiben eines Datensignals verbunden sind, und mit einer Zeilenzugriffsteuerung zur Aktivierung einer der Zeilenleitungen für die Auswahl einer der Speicherzellen und zur Steuerung eines Deaktivierungsvorgangs zur Deaktivierung einer der Zeilenleitungen.

Derartige integrierte Speicher sind beispielsweise aus der US 6,131,149 bekannt. Diese zeigt ein System mit einem synchronen Speicher, der ein Speicherzellenfeld umfasst, dessen Speicherzellen über einen Adressendecoder adressiert und anschließend ausgelesen werden können.

Ein integrierter Speicher weist im allgemeinen ein Speicherzellenfeld auf, das Spaltenleitungen und Zeilenleitungen umfaßt. Die Speicherzellen sind dabei in Kreuzungspunkten der Spaltenleitungen und Zeilenleitungen angeordnet. Zur Auswahl einer der Speicherzellen sind diese jeweils mit einer der Zeilenleitungen verbunden. Dazu wird beispielsweise ein Auswahltransistor von jeweiligen Speicherzellen durch eine aktivierte Zeilenleitung leitend geschaltet, wodurch im Anschluß ein Auslesen oder Schreiben eines Datensignals einer entsprechenden ausgewählten Speicherzelle erfolgen kann. Die ausgewählte Speicherzelle ist dazu über den Auswahltransistor mit einer der Spaltenleitungen verbunden, über die das entsprechende Datensignal ausgelesen beziehungsweise eingeschrieben wird.

In einem inaktiven Zustand sind die Zeilenleitungen üblicherweise deaktiviert, beispielsweise auf ein Vorladepotential vorgeladen oder auf Masse gelegt. Das heißt, nach dem Lesen oder Schreiben eines Datensignals wird die entsprechende aktivierte Zeilenleitung durch einen Deaktivierungsvorgang deaktiviert. Die Steuerung dieses Deaktivierungsvorgangs sowie die Aktivierung einer der Zeilenleitungen für die Auswahl einer der Speicherzellen erfolgt im allgemeinen durch eine Zeilenzugriffsteuerung.

Insbesondere bei synchronen Speichern wie sogenannten SDRAM oder SGRAM wird infolge steigender Anforderungen durch Erhöhung der Betriebsfrequenz (Taktrate) die Datenverarbeitungsgeschwindigkeit fortschreitend erhöht. Dadurch wird die Zugriffszeit für einen einzelnen Speicherzugriff zunehmend verkürzt. Dabei ist nach wie vor sicherzustellen, daß eine festgelegte minimale Zeitspanne, in der eine Zeilenleitung zum Lesen oder Schreiben eines Datensignals zu aktivieren ist, eingehalten wird. Diese minimale Zeitspanne ist meist physikalisch bedingt, beispielsweise durch die Länge der Zeilenleitung und die damit verbundene kapazitive Last.

Die minimale Zeit, in der eine Zeilenleitung nach einem Schreibvorgang geöffnet bleiben muß, um zu garantieren, daß die Speicherzellen korrekt beschrieben werden, wird als sogenannte Write Recovery Time bezeichnet. Diese Zeit muß eingehalten werden, damit kein Datenverlust beim Schreibvorgang entstehen kann. Die Write Recovery Time ist bei SDRAM oder SGRAM Speichern üblicherweise eine fest eingestellte Zeit, die entweder als analoge Zeit oder als eine Zeit definiert ist, die in Relation zu einem Taktzyklus eingestellt wird. Wenn ein Speicherbaustein in einem vergleichsweise großen Frequenzbereich betrieben wird, kann es vorkommen, daß infolge einer fest eingestellten Write Recovery Time der Datendurchsatz auch bei relativ hoher Betriebsfrequenz des Speichers vergleichsweise niedrig bleibt.

Die Aufgabe der vorliegenden Erfindung ist es, einen integrierten Speicher der eingangs genannten Art anzugeben, bei dem ein vergleichsweise hoher Datendurchsatz auch bei unterschiedlichen Betriebsfrequenzen des integrierten Speichers ermöglicht ist.

Die Aufgabe wird gelöst durch einen integrierten Speicher laut Anspruch 1.

Durch die Steuereinheit ist es möglich, die Write Recovery Time abhängig von der Betriebsfrequenz des Speichers einzustellen. Dadurch wird diese als frequenzabhängige Zeitgröße definiert und dementsprechend über die Steuereinheit eingestellt. Dadurch kann die Write Recovery Time auf die Betriebsfrequenz optimiert werden, so daß auch bei unterschiedlichen Betriebsfrequenzen ein vergleichsweise hoher Datendurchsatz erzielt werden kann. Sobald nach einem Schreibzugriff auf eine der Speicherzellen die Write Recovery Time abgelaufen ist, wird der Deaktivierungsvorgang der betreffenden Zeilenleitung mittels des Ausgangssignals der Steuereinheit ausgelöst.

Die Write Recovery Time wird dabei in Abhängigkeit eines sogenannten CAS-Latency-Signals bestimmt. Dieses Signal zeigt an, wann eine synchronisierte Datenausgabe nach außerhalb des Speicherzellenfeldes bei einem Lesezugriff auf eine der Speicherzellen beginnt. Dadurch wird bei einem Lesezugriff zu einem definierten Zeitpunkt ein Datenpaket auf einer Spaltenleitung erhalten. Das CAS-Latency-Signal wird bei synchronen Speicherbausteinen üblicherweise über einen sogenannten Mode Register Set Befehl programmiert. Das CAS-Latency-Signal wird dabei abhängig von der Betriebsfrequenz des Speichers programmiert und eingestellt, um bei einem Lesezugriff auf eine der Speicherzellen einen optimalen Datendurchsatz bei jeder Betriebsfrequenz zu erhalten. Dieses Signal ist daher geeignet, Rückschlüsse auf den Frequenzbereich des Speichers zu ziehen, und es für die Bestimmung der Write Recovery Time für einen Schreibzugriff auf eine der Speicherzellen zu nutzen. Diese kann in der Steuereinheit anhand des programmierten CAS-Latency-Signals passend zur Betriebsfrequenz eingestellt werden. Der Deaktivierungsvorgang einer der Zeilenleitungen wird dementsprechend durch das Ausgangssignal der Steuereinheit eingeleitet.

In einer Ausführungsform der Erfindung ist die Steuereinheit mit einem Anschluß für ein Taktsignal verbunden. Das Ausgangssignal der Steuereinheit ist aus dem Taktsignal abgeleitet, wobei ein Zeitpunkt einer Schaltflanke des Ausgangssignals über die Steuereinheit abhängig vom Zustand des am Eingang anliegenden CAS-Latency-Signals festgelegt ist.

Die Steuereinheit weist dazu vorteilhaft eine Verzögerungsschaltung auf, durch die das Taktsignal um eine oder mehrere Taktperioden verzögerbar und als Ausgangssignal ausgebbar ist. Das Auslösen des Deaktivierungsvorgangs einer der Zeilenleitungen wird demzufolge mittels der Verzögerungsschaltung um eine oder mehrere Taktperioden des Taktsignals verzögert, so daß die Write Recovery Time eingehalten ist.

Die Anzahl der zu verzögernden Taktperioden kann beispielsweise diskret eingestellt werden. Dazu weist die Steuereinheit vorteilhaft eine Selektionsschaltung auf, die mit der Verzögerungsschaltung und mit dem Eingang der Steuereinheit verbunden ist. Dabei wird die Anzahl der zu verzögernden Taktperioden über das am Eingang der Steuereinheit anliegende CAS-Latency-Signal in der Selektionsschaltung eingestellt. Diese ist mit der Verzögerungsschaltung verbunden, die abhängig von dem Ausgangssignal der Selektionsschaltung die entsprechende Verzögerung des Taktsignals vornimmt.

Weitere vorteilhafte Aus- und Weiterbildungen sind in abhängigen Ansprüchen angegeben.

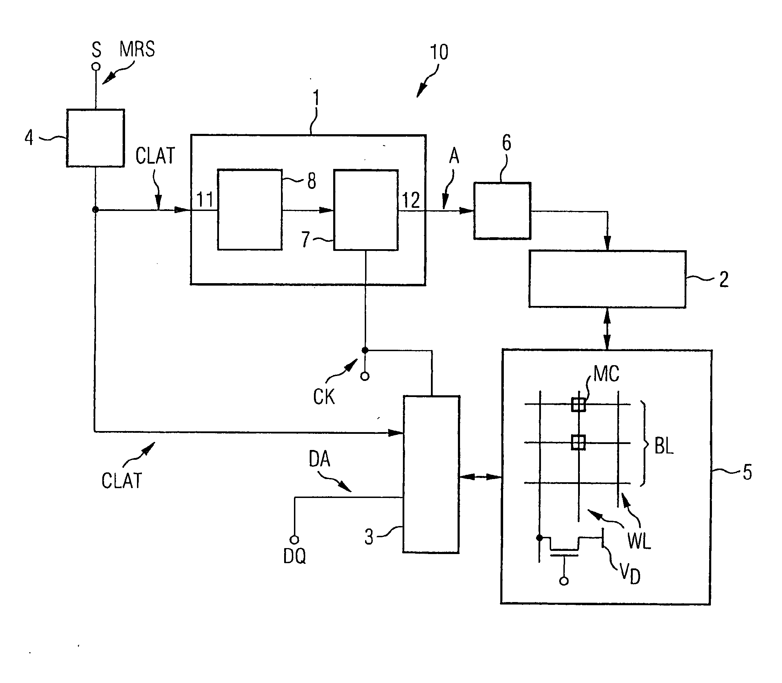

Die Erfindung wird im folgenden anhand der in der Zeichnung dargestellten Figur, die eine Ausführungsform der Erfindung darstellt, näher erläutert.

Die Figur zeigt ein Ausführungsbeispiel eines erfindungsgemäßen integrierten Speichers. Der Speicher 10 weist ein Speicherzellenfeld 5 auf, das Spaltenleitungen BL und Zeilenleitungen WL aufweist. Die Speicherzellen MC sind in Kreuzungspunkten von Zeilenleitungen WL und Spaltenleitungen BL angeordnet und jeweils mit einer der Zeilenleitungen WL und einer der Spaltenleitungen BL verbunden. Dies ist in der Figur der Übersichtlichkeit halber nur schematisch dargestellt. Die Speicherzellen MC werden über die jeweiligen Zeilenleitungen WL für einen Lese- oder Schreibvorgang ausgewählt. Über die Spaltenleitungen BL wird ein Datensignal DA aus einer der Speicherzellen MC ausgelesen oder in eine der Speicherzellen MC eingeschrieben. Das Auslesen oder Einschreiben eines Datensignals DA wird über den Datenausgang DQ vorgenommen. Dieser ist mit einer Spaltenzugriffsteuerung 3 verbunden, über die die entsprechende Spaltenleitung BL ausgewählt wird.

Die Zeilenzugriffsteuerung 2 dient zur Aktivierung einer der Zeilenleitungen WL zum Zwecke der Auswahl einer der Speicherzellen MC. Über die Zeilenzugriffsteuerung 2 wird ebenfalls ein Deaktivierungsvorgang zur Deaktivierung der entsprechenden Zeilenleitung WL nach deren Aktivierung einleitet. Zur Deaktivierung wird die entsprechende Zeilenleitung WL über ein Schaltmittel mit einem Deaktivierungspotential VD verbunden.

An dem Anschluß S des Speichers 10 ist beispielsweise ein Controller angeschlossen. Dieser überträgt einen sogenannten Mode Register Set Befehl MRS zur Einspeicherung in der Registerschaltung 4. Über diesen MRS-Befehl wird eine sogenannte CAS-Latency für den Speicher 10 programmiert. Am Ausgang der Registerschaltung 4 wird diesbezüglich ein CAS-Latency-Signal CLAT generiert. Dieses wird dazu benutzt, bei einem Lesezugriff auf eine der Speicherzellen MC den Beginn einer auf ein Taktsignal synchronisierten Datenausgabe nach außerhalb des Speicherzellenfeldes 5 festzulegen. Das CAS-Latency-Signal CLAT gibt dabei die Anzahl der Taktzyklen an, die bezogen auf den Beginn des Lesezugriffs abgewartet werden, um das Datensignal DA auszulesen. Das CAS-Latency-Signal CLAT ist dazu mit der Spaltenzugriffsteuerung 3 verbunden. Diese ist außerdem mit dem Taktsignal CK verbunden, das unterschiedliche Taktfrequenzen annehmen kann.

Das CLAT-Signal wird in Abhängigkeit der Taktfrequenz des Taktsignals CK durch den MRS-Befehl eingestellt. Die Abhängigkeit der ab Beginn des Lesezugriffs zur Datenausgabe abzuwartenden Taktzyklen, der CAS-Latency, von der Betriebsfrequenz des Taktsignals CK ist in der nachfolgenden Tabelle dargestellt. Darin ist auch die daraus abgeleitete Write Recovery Time TWR, auf die später eingegangen wird, enthalten.

| CAS-Latency (Taktzyklen TCK) | Taktfrequenz (MHz) | TWR (Taktzyklen TCK) |
|---|---|---|
| 2 | < 166 | 1 |
| 3, 4 | 166 - 300 | 2 |
| > 4 | > 300 | 3 |

Relativ kleine CAS-Latencies können nur in vergleichsweise niedrigen Frequenzbereichen verwendet werden. In höheren Frequenzbereichen müssen dementsprechend größere CAS-Latencies verwendet werden, da sich die Periodendauer TCK des Taktsignals CK entsprechend verkürzt.

Erfindungsgemäß kann nun abhängig von der eingestellten CAS-Latency auf den Frequenzbereich, in dem der Speicher betrieben wird, geschlossen werden. Mit dem Wissen des Frequenzbereichs kann eine zugehörige Write Recovery Time TWR für einen Schreibzugriff auf eine der Speicherzellen definiert werden.

Der Speicher 10 weist dazu eine Steuereinheit 1 auf, deren Eingang 11 mit dem Signalanschluß für das Signal CLAT verbunden ist. Der Ausgang 12 der Steuereinheit 1 ist mit der Zeilenzugriffsteuerung 2 über eine Umsetzschaltung 6 verbunden. Die Steuereinheit 1 gibt ein Ausgangssignal A aus, das zum Auslösen des Deaktivierungsvorgangs einer der Zeilenleitungen WL nach einem Schreibzugriff auf eine der Speicherzellen dient. Über die Umsetzschaltung 6 und die Zeilenzugriffsteuerung 2 wird der Deaktivierungsvorgang einer der Zeilenleitungen entsprechend dem Schaltzeitpunkt des Ausgangssignals A bezogen auf den Zugriffsbeginn ausgelöst. Mittels der Umsetzschaltung 6 können weitere relevante Einstellungen zum Auslösen des Deaktivierungsvorgangs vorgenommen werden.

Die Steuereinheit 1 weist eine Verzögerungsschaltung 7 auf, die mit einem Anschluß für das Taktsignal CK verbunden ist. Das Ausgangssignal A der Steuereinheit 1 ist aus dem Taktsignal CK abgeleitet. Das Taktsignal CK wird dabei um eine oder mehrere Taktperioden verzögert und als Ausgangssignal A ausgegeben. Die Verzögerungsschaltung 7 wird von der Selektionsschaltung 8 angesteuert, die mit dem Eingang 11 der Steuereinheit 1 verbunden ist. Über die Selektionsschaltung 8 wird die Anzahl der zu verzögernden Taktperioden anhand des Signal CLAT diskret eingestellt.

Über die Verzögerung des Ausgangssignals A wird die maßgebende Write Recovery Time TWR eingestellt. Wie in der oben dargestellten Tabelle angegeben, erhöht sich die Zeit TWR mit der Betriebsfrequenz des Taktsignals CK. Das heißt beispielsweise, daß infolge von höheren Betriebsfrequenzen die Anzahl der zu verzögernden Taktperioden erhöht werden muß. Dadurch wird der Deaktivierungsvorgang der entsprechenden Zeilenleitung nach einem Schreibzugriff auf eine der Speicherzellen angepaßt an die Betriebsfrequenz des Taktsignals ausgelöst, so daß die minimale Zeit, in der eine Zeilenleitung nach dem Schreiben geöffnet bleiben muß, eingehalten ist. Der Zeitpunkt der Schaltflanke des Ausgangssignals A wird abhängig vom Zustand des Signals CLAT am Eingang der Steuereinheit 1 festgelegt.

### Bezugszeichenliste

- 1: Steuereinheit
- 2: Zeilenzugriffsteuerung
- 3: Spaltenzugriffsteuerung
- 4: Registerschaltung
- 5: Speicherzellenfeld
- 6: Umsetzschaltung
- 7: Verzögerungsschaltung
- 8: Selektionsschaltung
- 10: Speicher
- 11: Eingang
- 12: Ausgang
- DA: Datensignal
- DQ: Datenausgang
- A: Ausgangssignal
- CK: Taktsignal
- MRS: Befehl
- WL: Zeilenleitung
- BL: Spaltenleitung
- MC: Speicherzellen
- VD: Deaktivierungspotential
- CLAT: CAS-Latency-Signal
- S: Anschluß

## Patentansprüche

1. Integrierter Speicher
- mit einem Speicherzellenfeld (5), das Spaltenleitungen (BL) und Zeilenleitungen (WL) aufweist,
- mit Speicherzellen (MC), die jeweils mit einer der Zeilenleitungen (WL) zur Auswahl einer der Speicherzellen (MC) und mit einer der Spaltenleitungen (BL) zum Auslesen oder Schreiben eines Datensignals (DA) verbunden sind,
- mit einer Zeilenzugriffssteuerung (2) zur Aktivierung einer der Zeilenleitungen (WL) für die Auswahl einer der Speicherzellen (MC) und zur Steuerung eines Deaktivierungsvorgangs zur Deaktivierung einer der Zeilenleitungen (WL),
**gekennzeichnet durch**
eine Steuereinheit (1) umfassend
- einen Eingang (11), der mit einem Signalanschluß für ein Signal (CLAT) verbunden ist, das bei einem Lesezugriff auf eine der Speicherzellen (MC) den Beginn einer auf ein Taktsignal (CK) synchronisierten Datenausgabe nach außerhalb des Speicherzellenfeldes (5) festlegt, wobei das Signal (CLAT) abhängig von einer Betriebsfrequenz des Speichers einstellbar ist, und
- einen Ausgang (12), der mit der Zeilenzugriffssteuerung (2) verbunden ist, zur Ausgabe eines vom Zustand des am Eingang (11) anliegenden Signals (CLAT) abhängigen Ausgangssignals (A) zum Auslösen des Deaktivierungsvorgangs einer der Zeilenleitungen (WL) nach einem Schreibzugriff auf eine der Speicherzellen.

2. Integrierter Speicher nach Anspruch 1,
**dadurch gekennzeichnet, daß**
- die Steuereinheit (1) mit einem Anschluß für ein Taktsignal (CK) verbunden ist,
- das Ausgangssignal (A) der Steuereinheit aus dem Taktsignal (CK) abgeleitet ist,
- die Steuereinheit (1) derart ausgebildet ist, daß ein Zeitpunkt einer Schaltflanke des Ausgangssignals (A) abhängig vom Zustand des am Eingang (11) anliegenden Signals (CLAT) festgelegt ist.

3. Integrierter Speicher nach Anspruch 2,
**dadurch gekennzeichnet, daß**
die Steuereinheit (1) eine Verzögerungsschaltung (7) aufweist, durch die das Taktsignal (CK) um eine oder mehrere Taktperioden verzögerbar und als das Ausgangssignal (A) ausgebbar ist.

4. Integrierter Speicher nach Anspruch 3,
**dadurch gekennzeichnet, daß**
die Steuereinheit (1) eine Selektionsschaltung (8) aufweist, die mit der Verzögerungsschaltung (7) und mit dem Eingang (11) der Steuereinheit (1) verbunden ist, zur diskreten Einstellung der Anzahl der zu verzögernden Taktperioden.

## Claims

1. Integrated memory
- with a memory cell field (5) comprising column lines (BL) and row lines (WL),
- with memory cells (MC), each connected with one of the row lines (WL) to choose one of the memory cells (MC) and with one of the column lines (BL) to read out or write a data signal (DA),
- with a row access controller (2) for activating one of the row lines (WL) to choose one of the memory cells (MC) and to control a deactivation process for deactivating one of the row lines (WL), **characterised by**
a control unit (1) comprising
- an input (11) connected with a signal terminal for a signal (CLAT) defining the start of data output to the outside of the memory cell field (5) synchronized on a clock signal in case of a reading access on one of the memory cells (MC), whereas the signal (CLAT) is adjustable in dependency of an operating frequency of the memory, and
- an output (12) connected with the row access controller (2) for outputting an output signal (A) depending on the status of the signal (CLAT) applied to the input (11) to trigger the deactivation process of one of the row lines (WL) after a writing access to one of the memory cells.

2. Integrated memory according to claim 1,
**characterized in that**
- the control unit (1) is connected to a terminal for a clock signal (CK),
- the output signal (A) of the control unit is derived from the clock signal (CK),
- the control unit (1) is formed such that a point in time of a slope of the output signal (A) is defined in dependency of the status of the signal (CLAT) applied to the input (11).

3. Integrated memory according to claim 2,
**characterized in that**
the control unit (1) comprises a delay circuit (7) through which the clock signal (CK) may be delayed by one or more clock periods and output as output signal (A).

4. Integrated memory according to claim 3,
**characterized in that**
the control unit (1) comprises a selection circuit (8) connected to the delay circuit (7) and to the input (11) of the control unit (1) to discreetly adjust the amount of clock periods to delay.

## Revendications

1. Mémoire intégrée
- avec une zone de cellules de mémoire (5) présentant des conducteurs de colonnes (BL) et des conducteurs de lignes (WL)
- avec des cellules de mémoire (MC) jointes respectivement à un des conducteurs de lignes (WL) pour la sélection d'une des cellules de mémoire (MC) et à un conducteur de colonnes (BL) pour sélectionner ou écrire un signal de données (DA).
- avec une commande d'accès de lignes (2) pour activer un des conducteurs de lignes (WL) à sélectionner une des cellules de mémoire (MC) et pour commander un processus de désactivation à désactiver un des conducteurs de lignes (WL), **caractérisée par**
une unité de commande (1) comprenant
- une entrée (11) jointe à une connexion de signal pour un signal (CLAT), qui détermine que quand une des cellules de mémoire (MC) et accédée à cause d'une lecture, le commencement de la distribution des données synchronisée sur un signal d'horloge se déroule vers l'extérieur de la zone de cellules de mémoire (5), le signal (CLAT) étant ajustable pour dépendre d'une fréquence de fonctionnement de la mémoire, et
- une sortie (12) jointe à la commande d'accès de lignes (2) pour la distribution d'un signal de sortie (A), qui est dépendant de l'état du signal adhérent à l'entrée (CLAT) pour déclencher un processus de désactivation d'un des conducteurs de lignes (WL) après un accès à une des cellules de mémoire à cause d'une écriture.

2. Mémoire intégrée selon la revendication 1,
**caractérisée en ce que**
- l'unité de commande (1) est jointe à une connexion pour un signal d'horloge (CK),
- le signal de sortie (A) de l'unité de commande est dérivé du signal d'horloge (CK),
- l'unité de commande est tellement conçue qu'un moment d'un flanc de commande du signal de sortie (A) est déterminé dépendant de l'état du signal (CLAT) adhérent à l'entrée (11).

3. Mémoire intégrée selon la revendication 2,
**caractérisée en ce que**
l'unité de commande (1) présente un circuit de ralentissement (7), qui permet de ralentir le signal d'horloge (CK) pour une ou plusieurs périodes d'horloge et de le faire passer pour le signal d'entrée (A).

4. Mémoire intégrée selon la revendication 3,
**caractérisée en ce que**
l'unité de commande (1) présente un circuit de sélection (8), qui est joint au circuit de ralentissement (7) et à l'entrée (11) de l'unité de commande (1) pour discrètement ajuster le nombre des périodes d'horloge à ralentir.
